(19) **Europäisches Patentamt** / **European Patent Office** / **Office européen des brevets**

(11) **EP 4 635 650 A1**

(12) **EUROPEAN PATENT APPLICATION**
published in accordance with Art. 153(4) EPC

(43) Date of publication:
**22.10.2025 Bulletin 2025/43**

(21) Application number: **24759041.7**

(22) Date of filing: **29.02.2024**

(51) International Patent Classification (IPC):
**B22F 1/05** (2022.01)  **B22F 1/07** (2022.01)
**B22F 1/107** (2022.01)  **B22F 7/04** (2006.01)
**B23K 35/02** (2006.01)  **B23K 35/30** (2006.01)
**H01L 23/00** (2006.01)  **B22F 9/24** (2006.01)

(52) Cooperative Patent Classification (CPC):
**B22F 1/05; B22F 1/07; B22F 1/107; B22F 7/04;**
**B23K 35/025; B23K 35/3006; H01L 24/27;**
**H01L 24/29; H01L 24/32; H01L 24/83;** B22F 1/052;
B22F 9/24; B22F 2007/042; H01L 2224/2929;
H01L 2224/29294;                          (Cont.)

(86) International application number:
**PCT/JP2024/007647**

(87) International publication number:
**WO 2025/182051 (04.09.2025 Gazette 2025/36)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **KYOCERA Corporation**
**Kyoto 612-8501 (JP)**

(72) Inventors:
• **AOKI Takahiro**
  **Kyoto-shi, Kyoto 612-8501 (JP)**
• **SATAKE Yu**
  **Kyoto-shi, Kyoto 612-8501 (JP)**

(74) Representative: **Viering, Jentschura & Partner**
**mbB**
**Patent- und Rechtsanwälte**
**Am Brauhaus 8**
**01099 Dresden (DE)**

(54) **PASTE COMPOSITION, SEMICONDUCTOR DEVICE AND METHOD FOR MANUFACTURING SAME, AND ELECTRONIC COMPONENT AND METHOD FOR MANUFACTURING SAME**

(57)   Disclosed is a paste composition containing silver particles (A) and a binder (B), in which the silver particles (A) contain 5 mass% or less of silver particles (A1) having a particle size greater than 20 $\mu$m with respect to 100 mass% of the silver particles (A), the silver particles (A) account for 95 mass% or greater with respect to 100 mass% of a total amount of the silver particles (A) and the binder (B), and a change rate represented by Formula (1) is 250% or greater:

$$\text{change rate} = (S1 - S0)/S0 \times 100 \ (\%) \ ... \ (1)$$

where S0 is a crystallite size at a Miller index (111) of silver particles in a dried product of the paste composition, and S1 is a crystallite size at Miller index (111) of silver particles in a treated product obtained by subjecting the dried product of the paste composition to a heating and pressurizing treatment at 15 MPa and 200°C for 2 minutes under a nitrogen atmosphere.

EP 4 635 650 A1

(52) Cooperative Patent Classification (CPC): (Cont.)
H01L 2224/29339; H01L 2224/32225;
H01L 2224/32245; H01L 2224/45015;
H01L 2224/45099; H01L 2224/48091;
H01L 2224/48227; H01L 2224/48247;
H01L 2224/73265; H01L 2224/83192;
H01L 2224/83439; H01L 2224/83447;
H01L 2224/8384; H01L 2224/92247;
H01L 2924/00; H01L 2924/00012;
H01L 2924/00014; H01L 2924/12041;
H01L 2924/15747; H01L 2924/181

**Description**

TECHNICAL FIELD

The present disclosure relates to a paste composition, a semiconductor device, a method for manufacturing the semiconductor device, an electronic component, and a method for manufacturing the electronic component.

BACKGROUND OF INVENTION

In recent years, power semiconductor devices have been actively developed with a wide band gap semiconductor element combined, such as silicon carbide (SiC) or gallium nitride (GaN), which have a small power loss. In the power semiconductor device, the wide band gap semiconductor element is bonded to another member such as a semiconductor support member by a bonding member formed of a bonding material.
The wide band gap semiconductor element has a characteristic that the element itself has high heat resistance and can operate at a high temperature of 250°C or greater by a large current. This characteristic is exhibited when operation heat generated from the element and the like is sufficiently dissipated. Thus, a bonding material is required to have excellent long-term high-temperature heat resistance in addition to conductivity and heat conductivity.
As the bonding material, a sintering material has been widely adopted. The sintering material is a paste composition containing fine metal particles. The fine metal particles are sintered at a temperature significantly lower than the melting point of the metal itself, and the sintered fine metal particles can acquire thermal conductivity and heat resistance equivalent to those of bulk metal.
The sintering materials are classified into a non-pressurized type and a pressurized type depending on a difference in bonding process. In the non-pressurized type, heating is performed during bonding, and no pressurization is performed. In the pressurized type, heating and pressurization are simultaneously performed during bonding.
Among them, the pressurized type is used in fields (in-vehicle inverters and the like) requiring high connection reliability typified by automobiles. This is because high connection reliability can be obtained by forming a dense sintered body by pressurization during bonding.
Although the known pressurized type is generally heated to a high temperature of 250°C or greater during bonding, there is a concern about damage to peripheral members due to high temperature heating and deterioration of connection reliability due to residual stress derived from thermal expansion. Thus, a pressurized-type sintered material capable of bonding at a low temperature is required.
For example, Patent Document 1 describes a technique of performing pressure bonding at a low bonding temperature of 200°C, focusing on a change in crystallite size before and after heat treatment.

CITATION LIST

PATENT LITERATURE

Patent Literature 1: JP 2020-136580 A

SUMMARY

SOLUTION TO PROBLEM

The present disclosure relates to the following [1] to [11].

[1] A paste composition containing:

silver particles (A); and
a binder (B),
in which
the silver particles (A) contain 5 mass% or less of silver particles (A1) having a particle size greater than 20 $\mu$m with respect to 100 mass% of the silver particles (A),
the silver particles (A) account for 95 mass% or greater with respect to 100 mass% of a total amount of the silver particles (A) and the binder (B), and
a change rate represented by Formula (1) is 250% or greater:

$$\text{change rate} = (S1 - S0)/S0 \times 100 \ (\%) \ ... \ (1)$$

where S0 is a crystallite size at a Miller index (111) of silver particles in a dried product of the paste composition, and

S1 is a crystallite size at a Miller index (111) of silver particles in a treated product obtained by subjecting the dried product of the paste composition to a heating and pressurizing treatment at 15 MPa and 200°C for 2 minutes under a nitrogen atmosphere.

[2] The paste composition according to [1], in which the silver particles (A) contain 50 mass% or less of silver particles (A2) having a particle size of from 1.0 to 20 $\mu$m with respect to 100 mass% of the silver particles (A).

[3] The paste composition according to [1] or [2], in which the silver particles (A) contain 50 mass% or greater of silver particles (A3) having a particle size less than 1.0 $\mu$m with respect to 100 mass% of the silver particles (A).

[4] The paste composition according to any one of [1] to [3], in which the silver particles (A) have a specific surface area of 1.4 m$^2$/g or greater.

[5] The paste composition according to any one of [1] to [4], in which the binder (B) includes one or more selected from the group consisting of a thermosetting resin and a thermoplastic resin.

[6] The paste composition according to any one of [1] to [5], in which the binder (B) has a 5 mass% weight reduction temperature of 250°C or greater.

[7] The paste composition according to any one of [1] to [6], further containing a solvent (C),

in which

the paste composition contains from 10 to 30 mass% of the solvent (C) with respect to 100 mass% of a total amount of the silver particles (A), the binder (B), and the solvent (C).

[8] A semiconductor device including a bonding portion containing the paste composition according to any one of [1] to [7].

[9] A method for manufacturing a semiconductor device including a semiconductor element and a semiconductor support member, the method including:

applying the paste composition according to any one of [1] to [7] to the semiconductor support member;
mounting the semiconductor element on the paste composition; and
heat-and-pressure bonding the semiconductor element and the semiconductor support member,
in which
the heat-and-pressure bonding is performed for from 0.5 to 10 minutes at a temperature from 180 to 300°C and a pressure from 1 to 30 MPa.

[10] An electronic component including a bonding portion containing the paste composition according to any one of [1] to [7].

[11] A method for manufacturing an electronic component including forming a bonding portion with the paste composition according to any one of [1] to [7].

DESCRIPTION OF EMBODIMENTS

In the bonding method described in Patent Document 1, a threshold value of adhesive strength, which is an evaluation criterion of sinterability, is 20 MPa, and it is difficult to say that sufficient bondability is provided.

An object of the present disclosure is to provide a paste composition which has high coatability, has high adhesive strength by heat-and-pressure bonding at a low temperature, and can perform bonding in which detachment due to a cooling and heating cycle hardly occurs, a semiconductor device using the paste composition, a method for manufacturing the semiconductor device, an electronic component, and a method for manufacturing the electronic component.

The present inventors have paid attention to a change in crystallite size of silver particles during heating and pressurization, and have found that by selecting the silver particles having good sinterability in a pressurization step, a paste composition which has high coatability, has high adhesive strength by heat-and-pressure bonding at a low temperature, and can perform bonding in which detachment due to a cooling and heating cycle hardly occurs, a semiconductor device using the paste composition, a method for manufacturing the semiconductor device, an electronic component, and a method for manufacturing the electronic component can be provided.

According to the present disclosure, it is possible to provide a paste composition which has high coatability, has high adhesive strength by heat-and-pressure bonding at a low temperature, and can perform bonding in which detachment due to a cooling and heating cycle hardly occurs, a semiconductor device using the paste composition, a method for manufacturing the semiconductor device, an electronic component, and a method for manufacturing the electronic component.

An embodiment of the present disclosure will be described in detail below.

In the following descriptions, notations of "from A to B" indicating a numerical range mean "A or greater and B or less" including endpoints, and when described as "may be from A to B, from C to D, or from E to F", an upper limit and a lower limit thereof can be freely combined. In a numerical range described herein, the upper or lower limit value of the numerical range may be replaced by a value presented in the examples.

[Paste composition]

A paste composition of the present disclosure is a paste composition containing silver particles (A) and a binder (B), in which the silver particles (A) contain 5 mass% or less of silver particles (A1) having a greater than 20 $\mu$m with respect to 100 mass% of the silver particles (A), the silver particles (A) particle size account for 95 mass% or greater with respect to 100 mass% of a total amount of the silver particles (A) and the binder (B), and a change rate represented by Formula (1) below is 250% or greater.

$$\text{change rate} = (S1 - S0)/S0 \times 100\ (\%) \dots (1)$$

Here, S0 is a crystallite size at a Miller index (111) of silver particles in a dry product of the paste composition.

S1 is a crystallite size at a Miller index (111) of silver particles in a treated product obtained by subjecting the dried product of the paste composition to a heating and pressurizing treatment at 15 MPa and 200°C for 2 minutes under a nitrogen atmosphere.

The paste composition of the present disclosure has good coatability, is capable of pressure bonding at a low temperature, and has high adhesive strength.

Although details of the reason are unknown, it is presumed that the reason is as follows. That is, crystal growth proceeds inside the particles and also proceeds by sintering of the particles. It is construed that sintering proceeds as a degree of progress of the crystal growth increases. In general, the smaller the crystallite size, the easier the crystal is grown; however, it is considered that the degree of crystal growth varies depending on the shape and size of the particles and the treatment conditions. In the silver particles having a large change rate of the crystallite size by a treatment (heating and pressurization at 15 MPa and 200°C for 2 minutes under a nitrogen atmosphere) assuming a bonding step, the silver particles are densely packed under the conditions, and a contact frequency is high, so that sintering easily proceeds. That is, when the change rate {((S1 - S0)/S0) × 100} of the silver particles (A) is 250% or greater, good sinterability can be exhibited during the heating and pressurizing treatment at a low temperature.

As described above, since the silver particles (A) exhibit good sinterability during the heating and pressurizing treatment at a low temperature, the silver particles (A) have high bonding performance. Therefore, the content of the binder (B) contained for bonding can be reduced. That is, in the paste composition of the present disclosure, the silver particles (A) account for 95 mass% or greater with respect to 100 mass% of the total amount of the silver particles (A) and the binder (B). As described above, since the paste composition of the present disclosure has a large content of the silver particles (A), a bonding portion having high thermal conductivity and high conductivity in addition to high bonding strength can be formed.

<Silver particle (A)>

The silver particles (A) have a change rate represented by Formula (1) of 250% or greater.

$$\text{change rate} = (S1 - S0)/S0 \times 100\ (\%) \dots (1)$$

Here, S0 is a crystallite size at a Miller index (111) of silver particles in a dry product of the paste composition. S1 is a crystallite size at a Miller index (111) of silver particles in a treated product obtained by subjecting the dried product of the paste composition to a heating and pressurizing treatment at 15 MPa and 200°C for 2 minutes under a nitrogen atmosphere.

When the change rate {((S1 - S0)/S0) × 100} is 250% or greater, it is possible to obtain a paste composition capable of performing bonding in which by heat-and-pressure bonding at a low temperature, the adhesive strength is high and detachment due to the cooling and heating cycle hardly occurs. The upper limit value of the change rate {((S1 - S0)/S0) × 100} is not particularly limited, and may be 500% or less from the viewpoint of reducing a structural change of a sintered layer due to a thermal history after bonding.

From this viewpoint, the change rate {((S1 - S0)/S0) × 100} may be from 255 to 475%, from 270 to 450%, from 285 to 425%, or from 300 to 400%.

The crystallite size S0 of the silver particles (A) may be from 30 to 70 nm. When the crystallite size is within the above range, crystals are likely to grow during heating and pressurization, and therefore sintering is likely to proceed. From this viewpoint, the crystallite size S0 may be from 40 to 60 nm.

The crystallite size S0 can be measured as follows. The silver particles (A) in the dried product of the paste composition are compacted into a cake. The crystallite size S0 can be calculated from the Scherrer equation for a Miller index (111) plane peak by a concentration method using a CuK$\alpha$ ray as a radiation source using an X-ray diffractometer with the cake applied on glass. Specifically, the crystallite size S0 can be determined by a method described in Examples.

In the silver particles (A), the crystallite size S1 may be from 105 to 420 nm. When the crystallite size is 105 nm or greater, a structural change of the sintered layer after bonding can be reduced. When the crystallite size is 420 nm or less, stress generated in the sintered layer can be reduced.

From this viewpoint, the crystallite size S1 may be from 120 to 400 nm, from 130 to 350 nm, or from 140 to 300 nm.

The crystallite size S1 can be measured as follows. The silver particles (A) in the dried product of the paste composition are compacted into a cake. A sintered body is obtained by heating the cake to 200°C at a temperature raising rate of 60°C/min while applying a pressure of 15 MPa under a nitrogen atmosphere, heating and pressurizing the cake at 15 MPa and 200°C for 2 minutes, and then lowering the temperature to room temperature (25°C) at a temperature lowering rate of 110°C/min. A powder is produced by grinding the sintered body with a mortar. The crystallite size S1 can be calculated from the Scherrer equation for the Miller index (111) plane peak by a focusing method using a CuK$\alpha$ ray as a radiation source using an X-ray diffractometer with the powder applied on glass. Specifically, the crystallite size S1 can be determined by a method described in Examples.

The change rate $\{((S1 - S0)/S0) \times 100\}$ tends to be improved by, for example, setting the particle size of the silver particles (A) within the range described later and setting the crystallite size S0 of the silver particles (A) within the range described later.

The change rate $\{((S1 - S0)/S0) \times 100\}$ of the silver particles can be easily measured by the measurement methods of S0 and S1 described above.

The average particle size of the silver particles (A) may be from 0.62 to 5.0 $\mu$m. When the average particle size is 0.62 $\mu$m or greater, the contact frequency between silver particles during pressurization increases, so that the sinterability is improved. When the average particle size is 5.0 $\mu$m or less, damage to a semiconductor element or a substrate during pressurization can be reduced. When the average particle size of the silver particles (A) is from 0.62 to 5.0 $\mu$m, the change rate $\{((S1 - S0)/S0) \times 100\}$ tends to be high.

From this viewpoint, the average particle size of the silver particles (A) may be from 0.65 to 3.0 $\mu$m, 2.0 $\mu$m or less, or 1.75 $\mu$m or less.

The shape of the silver particle (A) is not particularly limited, and examples thereof include a spherical shape and a flake shape. The shape of the silver particle (A) may be a spherical shape. The silver particles (A) may be primary particles or secondary particles in which the primary particles are aggregated.

Moreover, the silver particles (A) may be hollow particles or solid particles, and may be hollow particles from the viewpoint of low temperature sinterability. Here, a hollow particle means a particle having a void within the particle. If the silver particles (A) are hollow particles, a void may be present in a center portion of the silver particles. Also, a solid particle means a particle that is substantially free of a space within the particle.

The specific surface area of the silver particle (A) determined by a BET method may be 1.4 m$^2$/g or greater. When the specific surface area is 1.4 m$^2$/g or greater, contact between silver particles can be increased, and a ratio of highly active silver atoms on a particle surface can be increased. The specific surface area may be 2.0 m$^2$/g or less. When the specific surface area is 2.0 m$^2$/g or less, the viscosity of the paste composition can be reduced, and the aggregation of the silver particles can be reduced.

From this viewpoint, the specific surface area may be from 1.5 to 1.95 m$^2$/g.

The specific surface area of the silver particles (A) can be measured in accordance with the single point BET method through nitrogen adsorption using a specific surface area measuring device, and specifically can be measured by a method described in Examples.

The silver particles (A) account for 95 mass% or greater with respect to 100 mass% of the total amount of the silver particles (A) and the binder (B). When the silver particles (A) account for 95 mass% or greater, it is possible to obtain a paste composition capable of performing bonding in which by heat-and-pressure bonding at a low temperature, the adhesive strength is high and detachment due to the cooling and heating cycle hardly occurs.

The silver particles (A) may account for 99 mass% or less with respect to 100 mass% of the total amount of the silver particles (A) and the binder (B). When the silver particles (A) account for 99 mass% or less, the function of the binder (B) is sufficiently exerted, so that a paste composition having high coatability and capable of reducing the structural change of the sintered layer due to the thermal history after bonding can be produced.

From this viewpoint, the silver particles (A) may account for from 95 to 99 mass%, from 95.5 to 98.7 mass%, or from 96 to 98.5 mass%.

From the viewpoint of the sinterability, the silver may account for 60 mass% or greater, 80 mass% or greater, 90 mass% or greater, 95 mass% or greater, or 99 mass% or greater with respect to 100 mass% of a total amount of metal present in the paste composition, and metals other than silver may not be contained.

<<Silver particle (A1)>>

The silver particles (A) of the present disclosure contain 5 mass% or less of the silver particles (A1) having a particle size greater than 20 μm with respect to 100 mass% of the silver particles (A). The silver particles (A) may contain 0 mass% of the silver particles (A1). When the silver particles (A) contain 5 mass% or less of the silver particles (A1), a pressing load can be uniformly applied to a bonding layer without leaving a squeegee mark during printing application. Thus, when silver particles (A) contain 5 mass% or less of the silver particles (A1), it is possible to produce a paste composition which has high coatability and can perform bonding in which by heat-and-pressure bonding at a low temperature, the adhesive strength is high and detachment due to the cooling and heating cycle hardly occurs. From this viewpoint, the silver particles (A) may contain 2.5 mass% or less, 1.5 mass% or less, or 1.0 mass% or less of the silver particles (A1).

<<Silver particles (A2)>>

The silver particles (A) of the present disclosure may contain 50 mass% or less of the silver particles (A2) having a particle size of from 1.0 to 20 μm in 100 mass% of the silver particles (A).
When the silver particles (A) contain 50 mass% or less of the silver particles (A2), a uniform silver sintered layer can be formed. The silver particles (A) may contain 5 mass% or greater of the silver particles (A2). When the silver particles (A) contain 5 mass% or greater of the silver particles (A2), the contact frequency between silver particles can be improved.
From this viewpoint, the silver particles (A) may contain from 8 to 45 mass%, from 10 to 40 mass%, or from 15 to 36 mass% of the silver particles (A2).

<<Silver particle (A3)>>

The silver particles (A) of the present disclosure may contain 50 mass% or greater of the silver particles (A3) having a particle size less than 1.0 μm with respect to 100 mass% of the silver particles (A).
When the silver particles (A) contain 50 mass% or greater of the silver particles (A3), a uniform silver sintered layer can be formed. The silver particles (A) may contain 95 mass% or less of the silver particles (A3). When the silver particles (A) contain 95 mass% or less of the silver particles (A3), the contact frequency between silver particles can be improved.
From this viewpoint, the silver particles (A) may contain from 55 to 92 mass%, from 60 to 90 mass%, or from 64 to 85 mass% of the silver particles (A3).

(Method of producing silver particles (A))

A method of producing the silver particles (A) includes: a step of preparing a silver ammine complex solution by adding ammonia water to an aqueous solution containing a silver compound; and a step of preparing a silver particle-containing slurry by reducing, with a reducing compound, a silver ammine complex in the silver ammine complex solution prepared in the previous step.

(Step of preparing silver ammine complex solution)

In this step, ammonia water is added to an aqueous solution containing a silver compound, and a silver amine complex solution is prepared.
Examples of the silver compound include silver nitrate, silver chloride, silver acetate, silver oxalate, and silver oxide. From the viewpoint of solubility in water, the silver compound may be silver nitrate or silver acetate.
The added amount of ammonia may be, per mole of silver in the aqueous solution containing a silver compound, from 2 to 50 mol, 5 mol or greater, or 10 mol or greater. When the added amount of ammonia is within the range described above, the average particle size of the primary particles can be set to within the range described above.

(Step of preparing silver particle-containing slurry)

In this step, the silver ammine complex contained in the silver ammine complex solution prepared in the step described above is reduced by a reducing compound, and a silver particle-containing slurry is prepared.
Reduction of the silver ammine complex using a reducing compound causes the primary particles of the silver particles in the silver ammine complex to aggregate and thereby form secondary particles (hollow particles) having a void in the center.

Aggregation of the primary particles can be controlled by appropriately adjusting the amount of silver in the silver ammine complex and the content of the reducing compound, and thereby the average particle size of the resulting secondary particles can be set to within the range described above.

The reducing compound is not particularly limited as long as the reducing compound can reduce the silver ammine complex and cause the silver to precipitate. Examples of the reducing compound include hydrazine derivatives. Examples of the hydrazine derivative include hydrazine monohydrate, methylhydrazine, ethylhydrazine, n-propylhydrazine, i-propylhydrazine, n-butylhydrazine, i-butylhydrazine, sec-butylhydrazine, t-butylhydrazine, n-pentylhydrazine, i-pentylhydrazine, neo-pentylhydrazine, t-pentylhydrazine, n-hexylhydrazine, i-hexylhydrazine, n-heptylhydrazine, n-octylhydrazine, n-nonylhydrazine, n-decylhydrazine, n-undecylhydrazine, n-dodecylhydrazine, cyclohexylhydrazine, phenylhydrazine, 4-methylphenylhydrazine, benzylhydrazine, 2-phenylethylhydrazine, 2-hydrazinoethanol, and acetohydrazine. These may be used alone or in combination of two or more.

The reducing compound may account for, per mole of silver in the silver ammine complex, from 0.25 to 20.0 mol, 10.0 mol or less, or 5.0 mol or less. When the content of the reducing compound is within the range described above, the average particle size of the obtained secondary particles can be set to within the range described above.

Furthermore, the temperature of the silver ammine complex solution when reducing the silver amine complex may be less than 30°C, or may be from 0 to 20°C. If the temperature of the silver ammine complex solution is within this range, aggregation of the primary particles can be controlled, and the average particle size of the resulting secondary particles can be set to within the range described above.

<Binder (B)>

The binder (B) may contain one or more selected from a thermosetting resin and a thermoplastic resin.

<<Thermosetting resin>>

The thermosetting resin is not particularly limited and can be used as long as it is a thermosetting resin that is generally used in adhesive applications. The thermosetting resin may be a resin that is liquid at room temperature (25°C), or may be a resin that becomes a paste by being diluted with a solvent or the like. The thermosetting resin may include at least one type selected from cyanate resins, epoxy resins, acrylic resins, and maleimide resins. These may be used alone or in combination of two or more.

The cyanate resin is a compound having a -NCO group in the molecule, and is a resin in which the -NCO group is reacted by heating. Specific examples include 1,3-dicyanatobenzene, 1,4-dicyanatobenzene, 1,3,5-tricyanatobenzene, 1,3-dicyanatonaphthalene, 1,4-dicyanatonaphthalene, 1,6-dicyanatonaphthalene, 1,8-dicyanatonaphthalene, 2,6-dicyanatonaphthalene, 2,7-dicyanatonaphthalene, 1,3,6-tricyanatonaphthalene, 4,4'-dicyanatobiphenyl, bis(4-cyanatophenyl)methane, bis(3,5-dimethyl-4-cyanatophenyl)methane, 2,2-bis(4-cyanatophenyl)propane, 2,2-bis(3,5-dibromo-4-cyanatophenyl)propane, bis(4-cyanatophenyl)ether, bis(4-cyanatophenyl)thioether, bis(4-cyanatophenyl)sulfone, tris(4-cyanatophenyl)phosphite, tris(4-cyanatophenyl)phosphate, and cyanates obtained by a reaction between a novolac resin and a cyanogen halide. In addition, a prepolymer having a triazine ring formed by trimerizing cyanate groups of these polyfunctional cyanate resins can also be used. The prepolymer is obtained by polymerizing the polyfunctional cyanate resin monomer described above, using as a catalyst, for example, an acid such as a mineral acid or a Lewis acid, a base such as a sodium alcoholate or a tertiary amine, or a salt such as sodium carbonate.

A commonly known curing accelerator can be used as the curing accelerator for the cyanate resin. Examples thereof include, but are not limited to, organometallic complexes, such as zinc octylate, tin octylate, cobalt naphthenate, zinc naphthenate, and iron acetylacetone; metal salts, such as aluminum chloride, tin chloride, and zinc chloride; and amines, such as triethylamine, and dimethylbenzylamine. A single type of these curing accelerators can be used, or two or more types can be mixed and used.

The epoxy resin is a compound having one or more glycidyl groups per molecule, and is a resin in which the glycidyl group reacts by heating. The epoxy resin may be a compound containing two or more glycidyl groups per molecule. Examples thereof include, but are not limited to, bifunctional compounds produced by epoxidizing, for example, bisphenol compounds or derivatives thereof, such as bisphenol A, bisphenol F, and biphenol, diols having an alicyclic structure or derivatives thereof, such as hydrogenated bisphenol A, hydrogenated bisphenol F, hydrogenated bisphenol, cyclohexanediol, cyclohexanedimethanol, and cyclohexanediethanol, and aliphatic diols and derivatives thereof, such as butanediol, hexanediol, octanediol, nonanediol, and decanediol; trifunctional compounds produced by epoxidizing compounds having a trihydroxyphenyl methyl skeleton or an aminophenol skeleton; and polyfunctional compounds obtained by epoxidizing a phenolic novolac resin, a cresol novolac resin, a phenol aralkyl resin, a biphenyl aralkyl resin, a naphthol aralkyl resin, polybutadiene, or the like. The epoxy resin may be a liquid at room temperature (25 °C) by itself or as a mixture. It is also possible to use a compound containing one glycidyl group per molecule as a reactive diluent as is usually used. Examples of the reactive diluent include monofunctional aromatic glycidyl ethers, such as phenyl glycidyl ether and cresyl glycidyl ether, and aliphatic glycidyl ethers.

Examples of a curing agent for the epoxy resin include aliphatic amines, aromatic amines, dicyandiamides, dihydrazide compounds, acid anhydrides, phenol resins, and organic peroxides.

Examples of the dihydrazide compounds include carboxylic acid dihydrazides, such as adipic acid dihydrazide, dodecanoic acid dihydrazide, isophthalic acid dihydrazide, and p-oxybenzoic acid dihydrazide.

Examples of the acid anhydrides include phthalic anhydride, tetrahydrophthalic anhydride, hexahydrophthalic anhydride, endomethylene tetrahydrophthalic anhydride, dodecenylsuccinic anhydride, a reaction product between maleic anhydride and polybutadiene, and a copolymer of maleic anhydride and styrene.

Examples of the organic peroxide include hydroperoxide, dialkyl peroxide, dicumyl peroxide, benzoyl peroxide, lauroyl peroxide, acetyl peroxide, acyl peroxide, cumene peroxide, peroxyketals such as 1,1-di-t-butylperoxycyclohexane, peroxyesters such as t-butylperoxybenzoate, and so-called ordinary-temperature-curable organic peroxides such as methyl ethyl ketone peroxide.

Furthermore, a curing accelerator can be compounded to facilitate curing. Examples of the curing accelerator for the epoxy resin include imidazoles, triphenylphosphine or tetraphenylphosphine and salts thereof, and amine-based compounds and salts thereof, such as diazabicycloundecene. The curing accelerator may be an imidazole compound such as 2-methylimidazole, 2-ethylimidazole, 2-phenylimidazole, 2-phenyl-4-methylimidazole, 2-phenyl-4-methyl-5-hydroxymethyl imidazole, 2-phenyl-4,5-dihydroxymethyl imidazole, 2-$C_{11}H_{23}$-imidazole, or an adduct of 2-methylimidazole and 2,4-diamino-6-vinyltriazine. An imidazole compound having a melting point of 180°C or greater may be used.

Examples of the acrylic resin include (meth)acrylates having a hydroxyl group, such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, 1,2-cyclohexanediol mono(meth)acrylate, 1,3-cyclohexanediol mono(meth)acrylate, 1,4-cyclohexanediol mono(meth)acrylate, 1,2-cyclohexane dimethanol mono(meth)acrylate, 1,3-cyclohexane dimethanol mono(meth)acrylate, 1,4-cyclohexane dimethanol mono(meth)acrylate, 1,2-cyclohexane diethanol mono(meth)acrylate, 1,3-cyclohexane diethanol mono(meth)acrylate, 1,4-cyclohexane diethanol mono(meth)acrylate, glycerol mono(meth)acrylate, glycerol di(meth)acrylate, trimethylolpropane mono(meth)acrylate, trimethylolpropane di(meth)acrylate, pentaerythritol mono(meth)acrylate, pentaerythritol di(meth)acrylate, pentaerythritol tri(meth)acrylate, and neopentylglycol mono(meth)acrylate; and (meth)acrylates having a carboxyl group, obtained by reacting these (meth)acrylates having a hydroxyl group with a carboxylic acid or derivative thereof. Examples of dicarboxylic acids that can be used herein include oxalic acid, malonic acid, succinic acid, glutaric acid, adipic acid, pimelic acid, suberic acid, azelaic acid, sebacic acid, maleic acid, fumaric acid, phthalic acid, tetrahydrophthalic acid, hexahydrophthalic acid, and derivatives thereof.

Furthermore, examples of the acrylic resin include compounds having a (meth)acrylic group, including polyethers, polyesters, polycarbonates, and poly(meth)acrylates having a molecular weight of from 100 to 10000; (meth)acrylates having a hydroxy group; and (meth)acrylamides having a hydroxy group.

The maleimide resin is a compound containing one or more maleimide groups per molecule, and is a resin in which the maleimide group is reacted by heating. Examples of the maleimide resin include bismaleimide resins such as N,N'-(4,4'-diphenylmethane) bismaleimide, bis(3-ethyl-5-methyl-4-maleimidophenyl) methane, and 2,2-bis[4-(4-maleimidophenoxy)phenyl] propane. The maleimide resin may be a compound obtained by reacting a dimer acid diamine with maleic anhydride; or a compound obtained by reacting a maleimidated amino acid, such as maleimidoacetic acid or maleimidocaproic acid, with a polyol. The maleimidated amino acid is obtained by reacting maleic anhydride with aminoacetic acid or aminocaproic acid. The polyol may be a polyether polyol, a polyester polyol, a polycarbonate polyol, or a poly(meth)acrylate polyol, or may be free of aromatic rings.

<<Thermoplastic resin>>

The thermoplastic resin is not particularly limited and can be used as long as it is a thermoplastic resin that is generally used in adhesive applications. Examples thereof include an acrylic resin, a methacrylic resin, a vinyl-based resin, a carbonate-based resin, cellulose, a polyolefin resin, an ethylene-vinyl acetate copolymer, and a polyamide resin. At least one selected from the thermoplastic resins exemplified above may be included. These may be used alone or in combination of two or more.

The content of the binder (B) is 5.0 mass% or less in 100 mass% of the total amount of the silver particles (A) and the binder (B). When the content is 5.0 mass% or less, it is possible to fill a void of a structure formed by silver sintering without inhibiting the sintering of the silver particles.

The content of the binder (B) may be 0.1 mass% or greater in 100 mass% of the total amount of the silver particles (A) and the binder (B). When the content is 0.1 mass% or greater, it is possible to alleviate the stress applied to the sintered layer by filling the void of the structure formed by silver sintering with a resin.

From this viewpoint, the content may be from 0.1 to 5.0 mass%, from 0.5 to 4.8 mass%, from 1.0 to 4.5 mass%, or from 1.5 to 4.0 mass%.

<<Physical properties, etc.>>

A 5% weight reduction temperature of the binder (B) may be 250°C or greater. When the temperature is 250°C or greater, thermal decomposition of the resin during bonding can be reduced. The upper limit of the 5% weight reduction temperature of the binder (B) is not particularly limited, and may be 450°C or lower from the viewpoint of availability of the binder, compatibility with a solvent, and the like.

From this viewpoint, a 5 mass% weight reduction temperature of the binder (B) may be from 250 to 450°C, from 300 to 425°C, or from 350 to 400°C.

The 5% weight reduction temperature of the binder (B) can be measured by a simultaneous differential calorimetric and thermogravimetric apparatus, and specifically can be measured by a method described in Examples.

<Solvent (C)>

The paste composition of the present disclosure may further contain a diluent (C) from the viewpoint of workability.

Examples of the solvent (C) include butyl carbitol, cellosolve acetate, ethyl cellosolve, butyl cellosolve, butyl cellosolve acetate, butyl carbitol acetate, diethylene glycol dimethyl ether, diacetone alcohol, N-methyl-2-pyrrolidone (NMP), dimethylformamide, N,N-dimethylacetamide (DMAc), $\gamma$-butyrolactone, 1,3-dimethyl-2-imidazolidinone, 3,5-dimethyl-1-adamantanamine (DMA), and terpene ether such as dihydroterpinyloxyethanol. These may be used alone or in combination of two or more.

When the paste composition of the present disclosure contains the solvent (C), the paste composition may contain from 5 to 50 mass% of the solvent (C) with respect to 100 mass% of the paste composition. When the paste composition contains 5 mass% or greater of the solvent (C), good coatability can be imparted. When the paste composition contains 50 mass% or less of the solvent (C), sedimentation of silver particles when the paste composition is allowed to stand can be reduced, and a pot life is improved.

From this viewpoint, the paste composition may contain from 10 to 40 mass%, from 12 to 30 mass%, or from 15 to 25 mass% of the solvent (C).

When the paste composition of the present disclosure contains the solvent (C), the solvent (C) may account for from 10 to 30 mass% with respect to 100 mass% of the total amount of the silver particles (A), the binder (B), and the solvent (C).

When the content is 10 mass% or greater, good coatability can be imparted. When the solvent (C) accounts for 30 mass% or less, sedimentation of silver particles when the paste composition is allowed to stand can be reduced, and the pot life is improved.

From this viewpoint, the solvent (C) may account for from 12 to 25 mass%.

<Additional components>

In addition to the components described above, the paste composition of the present disclosure can contain, as necessary, additional additives that are generally compounded in this type of composition. Examples thereof includes stress-lowering agents, such as rubber or silicone; coupling agents; antifoaming agents; surfactants; coloring agents such as pigments or dyes; various polymerization initiators; antioxidants; solvents; flux agents; and the other various additives. Each of these additives may be used alone, or two or more may be mixed and used.

The paste composition of the present disclosure may or may not contain a resin containing an aromatic amine skeleton.

The total content of the silver particles (A), the binder (B), and the solvent (C) in the paste composition of the present disclosure may be from 80 to 100 mass%, from 90 to 99.95 mass%, or from 95 to 99.9 mass% with respect to 100 mass% of the paste composition.

The total content of the silver particles (A) and the binder (B) may be from 80 to 100 mass%, from 90 to 100 mass%, or from 95 to 99.9 mass% with respect to 100 mass% of the solid content of the paste composition.

Here, the solid content refers to a component obtained by removing the solvent (C) from the paste composition.

The paste composition of the present disclosure can be prepared by thoroughly mixing the silver particles (A), the binder (B), the solvent (C) contained as necessary, and various additives described above, then kneading the mixture with a disperser, a kneader, a three-roll mill, or the like, and subsequently defoaming the mixture.

<Physical property value, etc. of paste composition>

(Viscosity)

The viscosity of the paste composition of the present disclosure may be from 1 to 200 Pa·s, from 10 to 100 Pa·s, from 12 to 50 Pa·s, or from 15 to 25 Pa·s from the viewpoint of coatability.

The viscosity is a value measured at 25°C and a rotation speed of 2.0 rpm using an E-type viscometer (3° cone). Specifically, the viscosity can be measured by the method described in the Examples.

(Thixotropic index)

The thixotropic index of the paste composition of the present disclosure may be from 1 to 20, from 2 to 10, or from 3.5 to 7 from the viewpoint of coatability.

In the thixotropic index, a viscosity ($V_{2.0}$) at a rotation speed of 2.0 rpm and a viscosity ($V_{20}$) at a rotation speed of 20 rpm are measured at a temperature of 25°C using an E-type viscometer (3°), and a viscosity ratio thereof ($V_{2.0}/V_{20}$) is defined as the thixotropic index. Specifically, the thixotropic index can be measured by the method described in the Examples.

(Shear strength)

A cured product of the paste composition of the present disclosure may have a shear strength of 80 MPa or greater. When the shear strength is 80 MPa or greater, it is possible to perform bonding in which by heat-and-pressure bonding at a low temperature, the adhesive strength is high and detachment due to the cooling and heating cycle hardly occurs.

From this viewpoint, the shear strength of the cured product of the paste composition may be 85 MPa or greater, 90 MPa or greater, or 92 MPa or greater.

In the shear strength of the cured product of the paste composition, the paste composition is applied to a copper frame, a backside gold chip provided with a gold vapor deposition layer is mounted on a bonding surface of 2 mm × 2 mm, heating and pressure curing is performed at 200°C and 15 MPa for 2 minutes, and then thermal-time die shear strength at 260°C can be measured using a mount strength measuring apparatus. Specifically, the shear strength can be measured by the method described in the Examples.

(Volume resistivity)

The cured product of the paste composition of the present disclosure may have a volume resistivity of 4.0 $\mu\Omega$·cm or less. When the volume resistivity is 4.0 $\mu\Omega$·cm or less, resistance heat generation at the bonding portion can be reduced.

From this viewpoint, the volume resistivity of the cured product of the paste composition may be 3.5 $\mu\Omega$·cm or less, 3.4 $\mu\Omega$·cm or less, or 3.0 $\mu\Omega$·cm or less.

In the volume resistivity of the cured product of the paste composition, the paste composition is applied to a glass substrate so as to have a thickness of 30 $\mu$m and dried, and in a wiring obtained by curing the paste composition at 200°C and 15 MPa for 2 minutes, an electrical resistivity can be then measured by a four-terminal method using a resistivity meter. Specifically, the volume resistivity can be measured by the method described in the Examples.

[Semiconductor device and manufacturing method thereof]

The semiconductor device of the present disclosure has a bonding portion formed of the paste composition described above. Since the semiconductor device of the present disclosure has the bonding portion formed of the paste composition described above, it is possible to provide a semiconductor device for an in-vehicle component having good heat dissipation and connection reliability.

The semiconductor device may include a semiconductor element, a substrate, and a bonding portion that bonds the semiconductor element and the substrate. The bonding portion is formed of the paste composition described above.

A method for manufacturing a semiconductor device according to the present disclosure is a method for manufacturing a semiconductor device including a semiconductor element and a semiconductor support member, the method including applying the paste composition to the semiconductor support member; mounting the semiconductor element on the paste composition; and heat-and-pressure bonding the semiconductor element and the semiconductor support member, in which conditions for the heat-and-pressure bonding are 0.5 to 10 minutes at from 180 to 300°C and from 1 to 30 MPa.

When the heating temperature in the heat-and-pressure bonding is 180°C or greater, sintering sufficiently proceeds, and the bonding strength of the bonding portion is improved. When the heating temperature is 300°C or lower, degradation of members such as a semiconductor element and a semiconductor support member due to heat is reduced.

From this viewpoint, the heating temperature may be from 180 to 300°C, from 185 to 250°C, or from 190 to 210°C.

When the pressure in the heat-and-pressure bonding is 1 MPa or greater, sintering sufficiently proceeds, and the bonding strength of the bonding portion is improved. When the pressure is 30 MPa or less, breakage of members such as a semiconductor element and a semiconductor support member due to the pressure is reduced.

From this viewpoint, the pressure may be from 1 to 30 MPa, from 5 to 25 MPa, or from 10 to 20 MPa.

The semiconductor element may be any known semiconductor element, and examples thereof include transistors and diodes. Further examples of the semiconductor element include a light-emitting element such as an LED. The type of light-emitting element is not particularly limited, and examples thereof include those in which a nitride semiconductor, such as InN, AlN, GaN, InGaN, AlGaN, or InGaAlN is formed as a light-emitting layer on a substrate by a method such as an MOCVD (metal organic chemical vapor deposition) method.

Moreover, examples of the semiconductor support member include a support member formed of a material such as copper, copper-plated copper, a PPF (pre-plated lead frame), glass epoxy, and ceramic.

By using a die attach material of the present embodiment, the semiconductor element can also be bonded to a base material that has not been metal plated. The connection reliability of the semiconductor device obtained in this manner with respect to the temperature cycle after mounting is improved compared to that of known semiconductor devices. Furthermore, the electrical resistance value is sufficiently small with minimal change over time, and thus an advantage of achieving a long useful life with minimal reduction over time in output even when driven for a long period of time is achieved.

[Electronic component and manufacturing method thereof]

The electronic component of the present disclosure has a bonding portion formed by the paste composition described above. Since the electronic component of the present disclosure has the bonding portion formed of the paste composition described above, it is possible to provide an electronic component for an in-vehicle component having good heat dissipation and connection reliability.

The electronic component may include an electronic element, a substrate, and a bonding portion that bonds the electronic element and the substrate. The bonding portion is formed of the paste composition described above.

The method for manufacturing an electronic component of the present disclosure is a method for manufacturing an electronic component including forming a bonding portion with the paste composition described above.

EXAMPLES

As raw materials and the like and the following were used.

As raw materials and the like, those shown in Table 1 and the following were used.

(1) Silver particle

[Table 1]

Table 1

| | Product name | Company name | Average particle size ($\mu$m) | Specific surface area (m$^2$/g) |
|---|---|---|---|---|
| Silver particle | TC-728 | Tokuriki Honten Co., Ltd. | 0.68 | 1.91 |
| | TC-905 | Tokuriki Honten Co., Ltd. | 1.69 | 1.83 |
| | E-20 | Tokuriki Honten Co., Ltd. | 14.55 | 1.84 |
| | TC-506C | Tokuriki Honten Co., Ltd. | 3.96 | 0.31 |
| | TC-765 | Tokuriki Honten Co., Ltd. | 1.98 | 0.77 |
| | N300SA025 | Tokusen Kogyo Co., Ltd. | 0.4 | 2.4 |
| | LS0305 | Tokusen Kogyo Co., Ltd. | 0.28 | 1.7 |

(2) Binder (resin)

· jER1009 (bisphenol A solid epoxy resin, available from Mitsubishi Chemical Corporation, molecular weight: 3800, 5% weight reduction temperature: 359°C)
· JP-100 (epoxidized solid epoxy resin, available from Nippon Soda Co., Ltd., molecular weight: 1300, 5% weight reduction temperature: 377°C)

(3) Solvent

· TOE-100 (dihydroterpinyloxyethanol, available from Nippon Terpene Chemicals, Inc., molecular weight: 198.31)

(4) Additional components

· Curing agent: PERCUMYL D (dicumyl peroxide, available from NOF CORPORATION, molecular weight: 270.37)
· Flux agent: KE-604 (trade name: "PINECRYSTAL KE-604", hydride of acrylic acid-modified rosin, available from Arakawa Chemical Industries, Ltd.)

[Examples 1 to 7 and Comparative Examples 1 to 10]

The components were mixed according to the formulations shown in Table 2 and kneaded in a mill, resulting in a paste composition.
The obtained paste composition was evaluated as described later. The results are listed in Table 2.

[Evaluation]

(1) Crystallite sizes S0 and S1 and change rate thereof $\{((S1 - S0)/S0) \times 100\}$

The obtained paste composition was dried at 80°C for 30 minutes to obtain a cake.
The obtained cake was applied onto a glass to have a thickness of 200 $\mu$m, and the crystallite size S0 (nm) was calculated from the Scherrer equation with respect to the Miller index (111) plane peak by a focusing method using a CuK$\alpha$ ray as a radiation source with an X-ray diffractometer (product name: SmartLab SE, available from Rigaku Corporation).
Note that a split pseudo-Voigt function was used as the fitting function, FWHD was used as the width, and 0.94 was used as the Scherrer constant.
A sintered body is obtained by heating the cake to 200°C at a temperature raising rate of 60°C/min while applying a pressure of 15 MPa under a nitrogen atmosphere, heating and pressurizing the cake at 15 MPa and 200°C for 2 minutes, and then lowering the temperature to room temperature (25°C) at a temperature lowering rate of 110°C/min. A powder was obtained by grinding the sintered body with a mortar. The powder was applied onto a glass, and the crystallite size S1 (nm) was calculated from the Scherrer equation with respect to the Miller index (111) plane peak by a focusing method using a CuK$\alpha$ ray as a radiation source with an X-ray diffractometer (product name: SmartLab SE, available from Rigaku Corporation).
Note that a split pseudo-Voigt function was used as the fitting function, FWHD was used as the width, and 0.94 was used as the Scherrer constant.
In addition, the change rate $\{((S1 - S0)/S0) \times 100\}$ (%) was calculated from S0 and S1 described above.

(2) Viscosity

The viscosity of the resulting paste composition at a temperature of 25°C and a rotational speed of 2.0 rpm was measured using an E-type viscometer (available from Toki Sangyo Co., Ltd., product name: VISCOMETER-TV22, applied cone plate-type rotor: 3° $\times$ R14) (3° cone).

(3) Thixotropic Index

The resulting paste composition was measured for the viscosity ($V_{2.0}$) at a rotational speed of 2.0 rpm and the viscosity ($V_{20}$) at a rotational speed of 20 rpm at a temperature of 25°C using an E-type viscometer (available from Toki Sangyo Co., Ltd., product name: VISCOMETER-TV22, applied cone plate-type rotor: 3° $\times$ R14). A viscosity ratio ($V_{2.0}/V_{20}$) of the viscosity $V_{2.0}$ to the viscosity $V_{20}$ was defined as the thixotropic index.

(4) Volume resistivity

The resulting paste composition was applied onto a glass substrate (thickness: 1 mm) by a screen printing method so as to have a thickness of 30 $\mu$m, and dried at 120°C for 10 minutes, then the temperature was raised to 200°C at a temperature raising rate of 60°C/min, and curing was performed at 200°C and 15 MPa for 2 minutes to obtain a wiring.
The electrical resistivity of the obtained wiring was measured by a four-terminal method using a resistivity meter (product name "MCP-T600", available from Mitsubishi Chemical Corporation).

(5) Shear strength

The resulting paste composition was applied to a copper frame by stencil printing and dried at 120°C for 10 minutes, a backside gold chip provided with a gold vapor deposition layer was then mounted on a bonding surface of 2 mm × 2 mm, the temperature was raised to 200°C at a temperature raising rate of 60°C/min, and heating and pressure curing was performed at 200°C and 15 MPa for 2 minutes. The thermal-time die shear strength at 260°C was measured using a mount strength measuring apparatus.

(6) Cooling and heating cycle

(Production of bonded body)

The resulting paste composition was applied to a copper frame by stencil printing and dried at 120°C for 10 minutes, a backside gold silicon chip provided with a gold vapor deposition layer was then mounted on a bonding surface of 5 mm × 5 mm, the temperature was raised to 200°C at a temperature raising rate of 60°C/min, and heating and pressure curing was performed at 200°C and 15 MPa for 2 minutes to obtain a bonded body.

(Cooling and heating cycle treatment)

The resulting ten bonded bodies were subjected to a cooling and heating cycle treatment. As the cooling and heating cycle treatment, an operation of holding at -55°C for 30 minutes, then raising the temperature from -55°C to 150°C at a temperature raising rate of 30°C/min, holding at 150°C for 30 minutes, and then lowering the temperature at a temperature lowering rate of 30°C/min was defined as 1 cycle, and 2000 cycles were performed.
In the bonded body subjected to the cooling and heating cycle treatment, the presence or absence of detachment of the silicon chip was observed using an ultrasonic microscope (product name "FineSAT II", available from Hitachi Power Solutions Co., Ltd.) and evaluated according to the following criteria.

OK: 0 silicon chips were detached out of 10 silicon chips.
Failed: 1 or more silicon chips were detached out of 10 silicon chips.

(7) Particle size distribution

For each paste composition shown in Table 2, only silver particles among components of the paste composition were blended in the proportion shown in Table 2 to obtain a sample for measuring a particle size distribution of the silver particles.
For example, in the paste composition of Example 2, a measurement sample was obtained by blending 90 parts by mass of TC-728 and 10 parts by mass of TC-905.
For each measurement sample, the particle size distribution was measured using a laser diffraction particle size distribution measuring apparatus (product name: "SALAD-7500 nano", available from Shimadzu Corporation). From the particle size distribution, an average particle size (D50) was determined from a particle size (50% particle size D50) at which an integrated volume was 50%.
Based on the particle size distribution, the proportions of particles in three regions of 1.0 $\mu$m or less, from 1.0 to 20 $\mu$m, and greater than 20 $\mu$m were calculated from a frequency of the particle size distribution.

(8) Specific surface area

A sample for measuring the specific surface area of silver particles was prepared by the following operations. That is, for each paste composition shown in Table 2, only silver particles among components of the paste composition were blended in the proportion shown in Table 2 to obtain a sample for measuring the specific surface area of the silver particles. For example, in the paste composition of Example 2, a measurement sample was obtained by blending 90 parts by mass of TC-728 and 10 parts by mass of TC-905.

The obtained each measurement sample was degassed for 10 minutes at 60°C, and then the specific surface area of was measured by the single point BET method through nitrogen adsorption using a specific surface area measuring device (Monosorb, available from Quantachrome Corporation).

(9) 5% weight reduction temperature

Each resin (jER-1009 and JP-100) was housed in a simultaneous differential calorimetric and thermogravimetric apparatus (product name "TG/DTA 6200", available from Hitachi High-Tech Corporation). The temperature of the resin was raised from room temperature (25°C) at a temperature raising rate of 10°C/min and the temperature at which the weight of the resin decreased by 5 mass% was defined as the 5% weight reduction temperature of the resin.

[Table 2]

Table 2

| Category | | Item | Unit | Example 1 | 2 | 3 | 4 | 5 | 6 | 7 | Comparative Example 1 | 2 | 3 | 4 | 5 | 6 | 7 | 8 | 9 | 10 |
|---|---|---|---|---|---|---|---|---|---|---|---|---|---|---|---|---|---|---|---|---|
| Paste composition | Silver particle | TC-728 | Part(s) by mass | 100 | 90 | 80 | 75 | 75 | 70 | 75 | 60 | 50 | - | - | - | - | - | - | 75 | 75 |
| | | TC-905 | Part(s) by mass | - | 10 | 20 | 25 | 25 | 30 | - | 40 | 50 | - | - | - | - | - | - | 25 | 25 |
| | | E-20 | Part(s) by mass | - | - | - | - | - | - | - | - | - | 100 | 100 | - | - | - | - | - | - |
| | | TC506C | Part(s) by mass | - | - | - | - | - | - | 25 | - | - | - | - | 100 | - | - | - | - | - |
| | | TC-765 | Part(s) by mass | - | - | - | - | - | - | - | - | - | - | - | - | 100 | - | - | - | - |
| | | N300SA025 | Part(s) by mass | - | - | - | - | - | - | - | - | - | - | - | - | - | 100 | - | - | - |
| | | LS0305 | Part(s) by mass | - | - | - | - | - | - | - | - | - | - | - | - | - | - | 100 | - | - |
| | Binder (resin) | JER1009 | Part(s) by mass | - | - | - | - | 3.8 | - | - | - | - | - | - | - | - | - | - | - | - |
| | | JP-100 | Part(s) by mass | 1.8 | 1.8 | 1.8 | 1.8 | - | 1.8 | 1.8 | 1.8 | 1.8 | 1.8 | 1.8 | 1.8 | 1.8 | 1.8 | 1.8 | 7 | 15 |
| | Diluent | TOE-100 | Part(s) by mass | 24.8 | 24.8 | 24.8 | 24.8 | 27.7 | 24.8 | 24.8 | 24.8 | 24.8 | 24.8 | 24.8 | 24.8 | 24.8 | 24.8 | 24.8 | 20 | 15.5 |
| | Additional components | PERCUMYL D | Part(s) by mass | 0.18 | 0.18 | 0.18 | 0.18 | - | 0.18 | 0.18 | 0.18 | 0.18 | 0.18 | 0.18 | 0.18 | 0.18 | 0.18 | 0.18 | 0.70 | 1.50 |
| | | KE-604 | Part(s) by mass | 0.26 | 0.26 | 0.26 | 0.26 | 0.55 | 0.26 | 0.26 | 0.26 | 0.26 | 0.26 | 0.26 | 0.26 | 0.26 | 0.26 | 0.26 | 0.26 | 0.26 |
| | | Silver particles/(silver particles + binder) | mass% | 98 | 98 | 98 | 98 | 96 | 98 | 98 | 98 | 98 | 98 | 98 | 98 | 98 | 98 | 98 | 93 | 87 |
| Characteristics of silver particles | Particle size | 1.0 µm or less | Part(s) by mass | 82.0 | 75.2 | 68.3 | 64.9 | 64.9 | 61.5 | 62.0 | 54.6 | 47.8 | 13.0 | 0.0 | 1.9 | 11.1 | 99.5 | 99.9 | 64.9 | 64.9 |
| | | from 1.0 to 20 µm | Part(s) by mass | 18.0 | 24.8 | 31.7 | 35.1 | 35.1 | 38.5 | 37.1 | 45.4 | 52.2 | 87.0 | 83.7 | 94.5 | 88.9 | 0.5 | 0.1 | 35.1 | 35.1 |
| | | greater than 20 µm | Part(s) by mass | 0.0 | 0.0 | 0.0 | 0.0 | 0.0 | 0.0 | 0.9 | 0.0 | 0.0 | 0.0 | 16.3 | 3.6 | 0.0 | 0.0 | 0.0 | 0.0 | 0.0 |
| | | Average particle size | µm | 0.68 | 0.78 | 0.88 | 0.93 | 0.93 | 0.98 | 1.50 | 1.08 | 1.19 | 1.69 | 14.55 | 3.96 | 1.98 | 0.40 | 0.28 | 0.28 | 0.28 |
| | Crystallite size of (111) plane | Crystallite size S0 (not treated) | nm | 47 | 45 | 44 | 43 | 43 | 42 | 56 | 41 | 39 | 31 | 36 | 82 | 43 | 226 | 314 | 44 | 44 |
| | | Crystallite size S1 (after treatment) | nm | 212 | 195 | 178 | 170 | 170 | 162 | 182 | 145 | 128 | 44 | 149 | 90 | 65 | 118 | 163 | 171 | 171 |
| | | Change rate (S1 - S0)/S0 × 100 | % | 351 | 320 | 289 | 273 | 273 | 257 | 266 | 226 | 195 | 39 | 315 | 10 | 49 | -48 | -48 | 289 | 289 |
| | | Specific surface area | m²/g | 1.91 | 1.90 | 1.89 | 1.89 | 1.89 | 1.89 | 1.51 | 1.88 | 1.87 | 1.83 | 1.84 | 0.31 | 0.77 | 2.40 | 1.70 | 1.89 | 1.89 |
| Evaluation result | | Viscosity | Pa·s | 22 | 22 | 21 | 20 | 20 | 19 | 16 | 18 | 17 | 11 | 115 | 1.5 | 12 | 10 | 10 | 21 | 20 |
| | | Thixotropic index | - | 6.5 | 6.5 | 6.4 | 6.3 | 4.0 | 6.2 | 6.2 | 6.1 | 6.0 | 5.2 | 3.0 | 2.6 | 4.8 | 2.0 | 2.0 | 3.9 | 2.2 |
| | | Shear strength (measured at 260°C) | MPa | 95 | 95 | 92 | 95 | 95 | 88 | 90 | 76 | 75 | 51 | 91 | <5 | 15 | 8 | 7 | 55 | <5 |
| | | Volume resistivity | µΩ·cm | 2.6 | 2.3 | 2.3 | 3.3 | 3.4 | 3.3 | 2.8 | 3.1 | 3.5 | 4.8 | 3.4 | 4.5 | 5 | 4 | 3.9 | 8 | 95 |
| | | Presence or absence of detachment (5 x 5 mm chip) | - | OK | OK | OK | OK | OK | OK | OK | OK | OK | Failed | OK | Failed | Failed | Failed | Failed | OK | Failed |
| | | Cooling and heating cycle test (from -55 to 150°C) | - | OK | OK | OK | OK | OK | OK | OK | Failed | Failed | Failed | Failed | Failed | Failed | Failed | Failed | Failed | Failed |

In the paste composition of Examples, the change rate ({((S1 - S0)/S0) × 100} of the crystallite size of the (111) plane is 250% or greater, and the content of silver particles having a particle size greater than 20 μm in 100 mass% of silver particles is 5 mass% or less, so that the coatability is good, pressure bonding can be performed at a low temperature, and the adhesive strength is high.

On the other hand, since the paste compositions of Comparative Examples 1 to 3 and 5 to 8 had a change rate {((S1 - S0)/S0) × 100} less than 250%, at least one of the coatability, the pressure bondability at a low temperature, and the adhesive strength was poor.

In the paste composition of Comparative Example 4, since the content of silver particles having a particle size greater than 20 μm in 100 mass% of silver particles was greater than 5 mass%, at least one of the coatability, dispersibility, the pressure bondability at a low temperature, and the adhesive strength was poor.

In the paste compositions of Comparative Examples 9 to 10, since the content of the silver particles (A) in 100 mass% of the total amount of the silver particles (A) and the binder (B) was less than 95 mass%, at least one of the coatability, the dispersibility, the pressure bondability at a low temperature, and the adhesive strength was poor.

**Claims**

1. A paste composition comprising:

   silver particles (A); and
   a binder (B),
   wherein
   the silver particles (A) contain 5 mass% or less of silver particles (A1) having a particle size greater than 20 μm with respect to 100 mass% of the silver particles (A),
   the silver particles (A) account for 95 mass% or greater with respect to 100 mass% of a total amount of the silver particles (A) and the binder (B), and
   a change rate represented by Formula (1) is 250% or greater:

   $$\text{change rate} = (S1 - S0)/S0 \times 100 \ (\%) \ ... \ (1)$$

   where S0 is a crystallite size at a Miller index (111) of silver particles in a dried product of the paste composition, and
   S1 is a crystallite size at a Miller index (111) of silver particles in a treated product obtained by subjecting the dried product of the paste composition to a heating and pressurizing treatment at 15 MPa and 200°C for 2 minutes under a nitrogen atmosphere.

2. The paste composition according to claim 1, wherein the silver particles (A) contain 50 mass% or less of silver particles (A2) having a particle size from 1.0 to 20 μm with respect to 100 mass% of the silver particles (A).

3. The paste composition according to claim 1 or 2, wherein the silver particles (A) contain 50 mass% or greater of silver particles (A3) having a particle size less than 1.0 μm with respect to 100 mass% of the silver particles (A).

4. The paste composition according to any one of claims 1 to 3, wherein the silver particles (A) have a specific surface area of 1.4 m²/g or greater.

5. The paste composition according to any one of claims 1 to 4, wherein the binder (B) includes one or more selected from the group consisting of a thermosetting resin and a thermoplastic resin.

6. The paste composition according to any one of claims 1 to 5, wherein the binder (B) has a 5 mass% weight reduction temperature of 250°C or greater.

7. The paste composition according to any one of claims 1 to 6, further comprising a solvent (C),
   wherein
   the paste composition contains from 10 to 30 mass% of the solvent (C) with respect to 100 mass% of a total amount of the silver particles (A), the binder (B), and the solvent (C).

8. A semiconductor device comprising a bonding portion containing the paste composition according to any one of claims 1 to 7.

9. A method for manufacturing a semiconductor device including a semiconductor element and a semiconductor support member, the method comprising:

applying the paste composition according to any one of claims 1 to 7 to the semiconductor support member;
mounting the semiconductor element on the paste composition; and
heat-and-pressure bonding the semiconductor element and the semiconductor support member,
wherein
the heat-and-pressure bonding is performed for from 0.5 to 10 minutes at a temperature from 180 to 300°C and a pressure from 1 to 30 MPa.

10. An electronic component comprising a bonding portion containing the paste composition according to any one of claims 1 to 7.

11. A method for manufacturing an electronic component comprising forming a bonding portion with the paste composition according to any one of claims 1 to 7.

## INTERNATIONAL SEARCH REPORT

| International application No. |
|---|
| **PCT/JP2024/007647** |

**A. CLASSIFICATION OF SUBJECT MATTER**

*H01L 21/52*(2006.01)i
FI:   H01L21/52 D

According to International Patent Classification (IPC) or to both national classification and IPC

**B. FIELDS SEARCHED**

Minimum documentation searched (classification system followed by classification symbols)

H01L21/52

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2020-136580 A (OSAKA SODA CO., LTD.) 31 August 2020 (2020-08-31) paragraphs [0053], [0068]-[0075] | 1-11 |
| Y | WO 2014/069074 A1 (KAKEN TECH CO., LTD.) 08 May 2014 (2014-05-08) table 2 | 1-11 |
| A | JP 2019-052237 A (TAMURA CORPORATION) 04 April 2019 (2019-04-04) paragraph [0032], table 1 | 1-11 |
| A | WO 2011/040521 A1 (TODA KOGYO CORP.) 04 July 2011 (2011-07-04) table 2 | 1-11 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **19 April 2024** | **07 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
**Information on patent family members**

International application No.

**PCT/JP2024/007647**

| Patent document cited in search report | | | Publication date (day/month/year) | Patent family member(s) | | | Publication date (day/month/year) |
|---|---|---|---|---|---|---|---|
| JP | 2020-136580 | A | 31 August 2020 | (Family: none) | | | |
| WO | 2014/069074 | A1 | 08 May 2014 | US | 2015/0115018 | A1 | |
| | | | | table 2 | | | |
| | | | | JP | 14-69074 | A1 | |
| | | | | US | 2019/0139930 | A1 | |
| | | | | EP | 2827341 | A1 | |
| | | | | CN | 104246910 | A | |
| | | | | KR | 10-2014-0134303 | A | |
| | | | | TW | 201416404 | A | |
| JP | 2019-052237 | A | 04 April 2019 | (Family: none) | | | |
| WO | 2011/040521 | A1 | 04 July 2011 | CN | 102470436 | A | |
| | | | | table 2 | | | |
| | | | | JP | 2011-80094 | A | |
| | | | | TW | 201124215 | A | |
| | | | | KR | 10-2012-0082347 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020136580 A

- JP 100 A